Europäisches Patentamt

European Patent Office

Office européen des brevets

(19)

(11) **EP 0 692 159 B1**

(12) **EUROPÄISCHE PATENTSCHRIFT**

(45) Veröffentlichungstag und Bekanntmachung des Hinweises auf die Patenterteilung:
**10.09.1997 Patentblatt 1997/37**

(21) Anmeldenummer: **94906847.2**

(22) Anmeldetag: **08.02.1994**

(51) Int Cl.⁶: **H03K 17/95**, H03K 17/945

(86) Internationale Anmeldenummer:
**PCT/DE94/00126**

(87) Internationale Veröffentlichungsnummer:
**WO 94/23499 (13.10.1994 Gazette 1994/23)**

(54) **ZWEIDRAHT-EIN-AUS-SCHALTER**

TWO-WIRE ON/OFF SWITCH

INTERRUPTEUR MARCHE-ARRET A DEUX FILS

(84) Benannte Vertragsstaaten:
**CH DE FR GB IT LI**

(30) Priorität: **02.04.1993 DE 4310910**

(43) Veröffentlichungstag der Anmeldung:
**17.01.1996 Patentblatt 1996/03**

(73) Patentinhaber: **SIEMENS AKTIENGESELLSCHAFT**
**80333 München (DE)**

(72) Erfinder: **HERFURTH, Michael**
**D-82205 Gilching (DE)**

(56) Entgegenhaltungen:
EP-A- 0 019 813          EP-A- 0 131 146
DE-C- 4 233 488          US-A- 3 764 880
US-A- 3 815 007          US-A- 4 015 472
US-A- 4 242 665          US-A- 4 404 497

**Beschreibung**

Die Erfindung betrifft einen Zweidraht-Ein-Aus-Schalter nach dem Oberbegriff des Patentanspruchs 1.

Ein solcher Schalter ist bereits aus der EP 0 131 146 B1 bekannt. Das Problem solcher Zweidrahtschalter ist, daß einerseits im durchgeschalteten Zustand eine möglichst geringe Restspannung am elektronischen Schaltelement anliegen soll, andererseits soll diese Spannung ausreichen, die Steuerschaltung zu versorgen. Deshalb wird ein DC-DC-Wandler verwendet, der aus einer Spannung, wie sie beispielsweise an einer in Serie zum Schaltelement angeordneten Diode abfällt, eine Spannung erzeugt, die ausreicht, die Steuerschaltung zu versorgen. In der Steuerschaltung des bekannten Zweidraht-Ein-Aus-Schalters ist dabei ein Taktgenerator vorgesehen, der den Transistor des DC-DC-Wandlers periodisch ansteuert. Der verwendete DC-DC-Wandler benötigt daher eine geeignete Steuerschaltung.

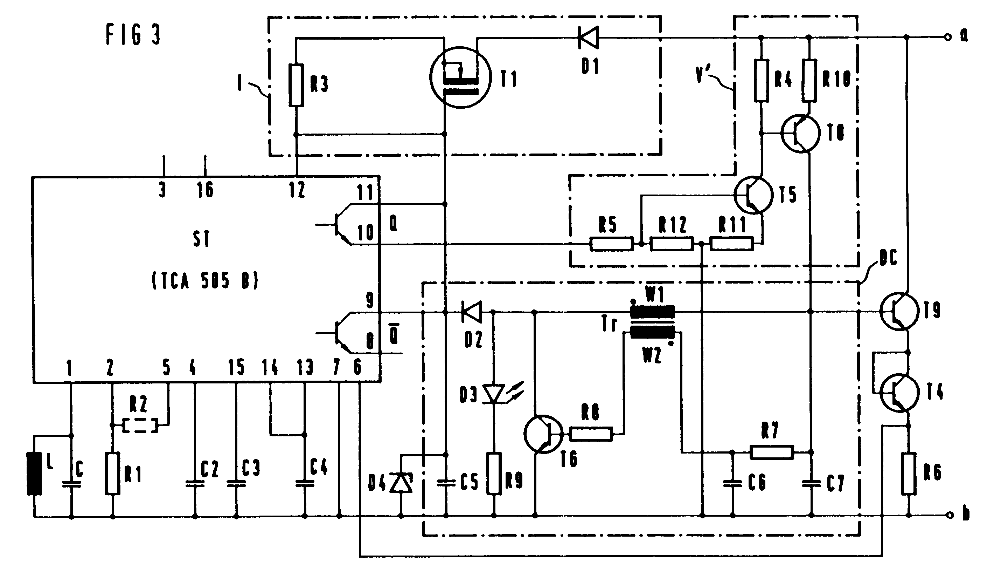

Aus EP 0 019 813 ist ein gattungsgemäßer Ein/Ausschalter bekannt. Insbesondere Figur 3 zeigt ein (Drossel-) Wandler, der einen Taktgenerator enthält. Dieser Taktgenerator kann beispielsweise aus einem internen astabilen Multivibrator bestehen. Der Wandler fängt dann an zu schwingen, sobald ein Strom an seiner Primärseite vorliegt. Als DC-DC-Wandler werden vorzugsweise induktive Wandler verwendet.

Die Aufgabe vorliegender Erfindung ist also, einen Zweidraht-Ein-Aus-Schalter mit einem von einer speziellen Steuerschaltung unabhängigen DC-DC-Wandler anzugeben, der außerdem mit nur wenigen Bauteilen auskommt.

Die Aufgabe wird bei einem gattungsgemäßen Zweidraht-Ein-Aus-Schalter durch die Merkmale des Patentanspruchs 1 gelöst.

Die erfindungsgemäßen DC-DC-Wandler lassen sich sehr vorteilhaft in induktiven Näherungsschaltern, beispielsweise mit dem Steuerbaustein TCA 505 von Siemens verwenden.

Die Erfindung soll nachfolgend anhand von Ausführungsbeispielen mit Hilfe von Figuren näher erläutert werden. Dabei zeigen

| | |
|---|---|
| Figur 1 | ein Prinzipschaltbild eines induktiven Zweidraht-Näherungsschalters mit einem selbstschwingenden DC-DC-Wandler, |
| die Figuren 2 und 3 | detaillierte Schaltbilder von Ausführungsformen eines Zweidraht-Näherungsschalters mit einem erfindungsgemäßen DC-DC-Wandler und |
| Figur 4 | ein weiteres detailliertes Schaltbild eines Zweidraht-Näherungsschalters mit einem erfindungsgemäß erweiterten DC-DC-Wandler. |

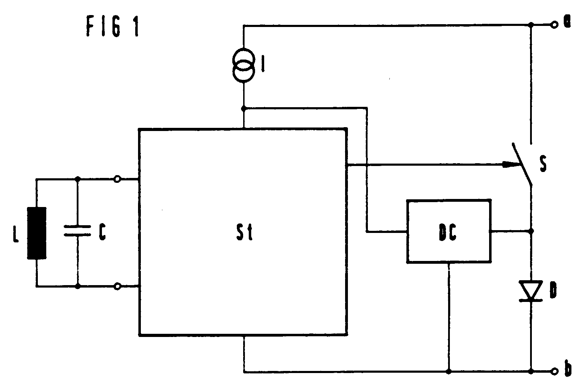

Figur 1 zeigt einen induktiven Zweidraht-Näherungsschalter. Ein erster Anschluß a kann mit dem einen Pol einer Spannungsquelle und ein zweiter Anschluß b mit dem einen Anschluß einer Last verbunden werden, wobei dann der andere Anschluß der Last mit dem anderen Pol der Spannungsquelle verbunden wird. Bei geöffnetem elektronischen Schaltelement S fließt durch die Last nur ein geringer Strom kleiner 1mA von der Spannungsquelle. Damit versorgt die Spannungsquelle über eine Stromversorgungsschaltung I eine Steuerschaltung St. Die Steuerschaltung St ist extern mit einem Parallelschwingkreis aus einer Spule L und einem Kondensator C beschaltet. Nähert man der Spule L ein Metallteil, so wird der Schwingkreis gedämpft und die Steuerschaltung St gibt von ihrem Ausgang Q ein Signal, ggf. über einen Verstärker, an das elektronische Schaltelement S, worauf dieses geschlossen wird. Daraufhin fließt ein Strom durch das elektronische Schaltelement S, die dazu in Serie geschaltete Diode D, die einen von der Höhe des Laststroms weitgehend unabhängigen Spannungsabfall bewirkt und die angeschlossene, aber nicht dargestellte Last. Die nun am elektronischen Schaltelement S und der Diode D abfallende Spannung würde nicht ausreichen, die Steuerschaltung St über die Stromversorgungsschaltung I weiter zu versorgen. Aus diesem Grund ist in erfindungsgemäßer Weise ein selbstschwingender DC-DC-Wandler DC derart angeordnet, daß er eingangsseitig mit der an der Diode abfallenden Spannung beaufschlagt und ausgangsseitig mit der Steuerschaltung St verbunden ist und diese mit einer ausreichenden Spannung versorgt.

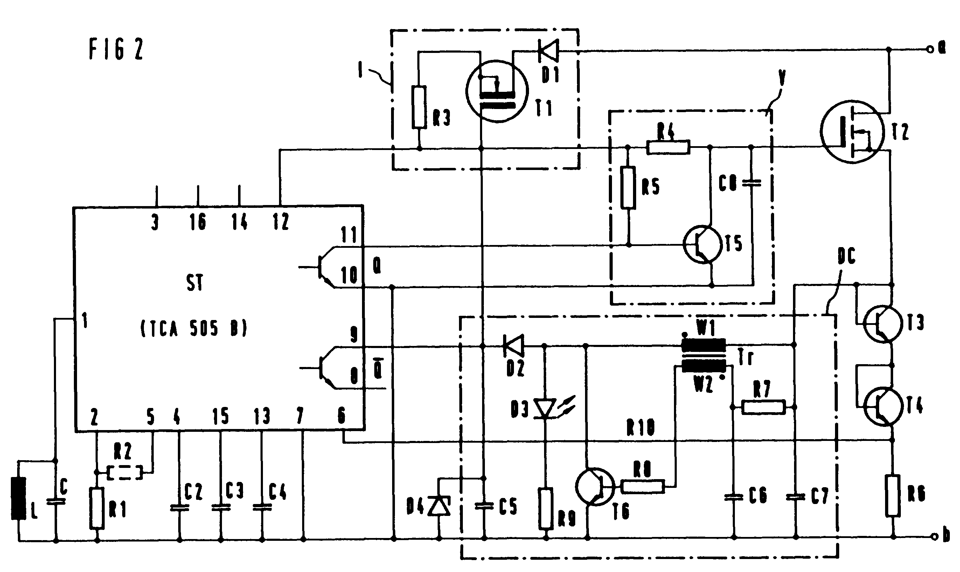

Figur 2 zeigt nun ein detailliertes Schaltbild eines erfindungsgemäßen induktiven Zweidraht-Näherungsschalters. Zwischen den Anschlüssen 1 und 7 der Steuerschaltung St, die beispielsweise durch den integrierten Baustein TCA 505B von Siemens gegeben sein kann, ist der aus der Spule L und dem Kondensator C bestehende Parallelschwingkreis geschaltet. Der Anschluß 2 der Steuerschaltung St ist über einen Widerstand R1, mit dem der Schaltabstand eingestellt werden kann, mit dem zweiten Anschluß b des Näherungsschalters, der gleich dem Masseanschluß ist, verbunden. Zwischen den Anschlüssen 2 und 5 kann zur Einstellung der Schalthysterese ein Widerstand R2 geschaltet werden, was durch gestrichelte Darstellung angedeutet ist. Die Anschlüsse 4, 13 und 15 sind jeweils über Kondensatoren C2, C3 und C4 mit dem Masseanschluß 7 verbunden. Die mit dem Versorgungsanschluß 12 der Steuerschaltung St verbundene Stromversorgungsschaltung I ist in an sich bekannter Weise mit einem selbstleitenden Feldeffekttransistor T1 und einem Widerstand R3 sowie einer zum Feldeffekttransistor T1 in Serie geschalteten Diode D1 gebildet. Durch die Anschlüsse 10 und 11 ist ein erster Ausgang Q und durch die Anschlüsse 8 und 9 ein zweiter Ausgang $\overline{Q}$ der Steuerschaltung St gegeben, wobei die beiden Ausgänge Q, $\overline{Q}$ als Open-Kollektor-Ausgänge ausgebildet sind und wobei der Emitter des Ausgangstransistor des Ausgangs Q mit Masse verbunden ist und der Emitter des Aus-

gangstransistors des Ausgangs $\overline{Q}$ nicht angeschlossen ist. Der Ausgang Q der Steuerschaltung St steuert über einen Verstärker V den Steueranschluß des mit einem Logic-Level-MOSFET T2, d. h. mit einem auf logische Pegel ansprechenden MOSFET, gebildeten elektronischen Schaltelements. Der Verstärker V ist dabei mit einem in Emitterschaltung betriebenen Transistor T5, einem Basiswiderstand R5 und einem Kollektorwiderstand R4 gebildet, wobei außerdem der Kollektor-Emitter-Strecke des Transistors T5 ein Kondensator C8 parallel geschaltet ist und wobei der Verstärker V von der Stromversorgungsschaltung I versorgt wird.

In Serie zum MOSFET T2 sind zwei als Dioden geschaltete Transistoren T3, T4 sowie ein Widerstand R6 geschaltet. Sie bilden zusammen mit dem MOSFET T2 die Schaltstrecke des Näherungsschalters. Die Spannung am Widerstand R6 wird einem Anschluß 6 der Steuerschaltung St zur Überstromerfassung zugeführt. Der Spannungsabfall an den beiden Dioden T3 und T4 und am Widerstand R6 bilden die Eingangsspannung für einen DC-DC-Wandler DC, dessen Ausgang ebenfalls mit dem Versorgungsanschluß 12 der Steuerschaltung St verbunden ist. Dem Ausgang des DC-DC-Wandlers DC ist außerdem eine Zenerdiode D4 parallel geschaltet.

Bei dem Schaltbild gemäß Figur 2 ist ein erstes Ausführungsbeispiel eines erfindungsgemäßen DC-DC-Wandlers DC mit einem Hochsetzsteller dargestellt. Der Hochsetzsteller wird dabei durch die Primärwicklung W1 eines Transformators Tr, einen Transistor T6, eine erste Diode D2 und einen ersten Kondensator C5 gebildet, wobei die Spannung am ersten Kondensator C5 gleich einer ersten Ausgangsspannung der Schaltungsanordnung ist. Die Basis des Transistors T6 ist mit dem Verbindungspunkt eines seriellen RC-Glieds, das mit einem ersten Widerstand R7 und einem zweiten Kondensator C6 gebildet und parallel zum Eingang des DC-DC-Wandlers angeordnet ist, über einen zweiten Widerstand R8 und eine erste Sekundärwicklung W2 des Transformators Tr verbunden. Parallel zum Eingang des DC-DC-Wandlers DC ist ein dritter Kondensator C7 als Pufferkondensator geschaltet. Parallel zur Kollektor-Emitter-Strecke des Transistors T6 sind eine Leuchtdiode D3 und ein dazu seriell geschalteter Widerstand R9 angeordnet.

Diese erfindungsgemäße Schaltungsanordnung schwingt bereits bei einer Eingangsspannung an, die der Basis-Emitter-Schwelle des Transistors T6 entspricht. Sie arbeitet dabei in gewissen Grenzen selbstregelnd, d. h., daß überschüssige Energie am Eingang nicht zwangsweise durch den Wandler gepumpt wird, so daß sich eine in gewissen Grenzen konstante erste Ausgangsspannung ergibt. Die erste Ausgangsspannung kann bei einer Eingangsspannung von etwa 0,7 Volt bis 2 Volt zu 4 Volt bis 6 Volt gewählt werden, so daß sich damit die Steuerschaltung St für den induktiven Zweidraht-Näherungsschalter versorgen läßt. Im Betrieb des DC-DC-Wandlers DC stellen sich dreieckförmige Ströme in der Primärwicklung W1 des Transformators Tr ein, so daß die Sperrverzögerungsverluste der ersten Diode D2 auf ein Minimum sinken.

Der mit einem Hochsetzsteller gebildete DC-DC-Wandler DC gemäß der Schaltungsanordnung nach Figur 2 läßt sich auch in einem Zweidraht-Näherungsschalter mit einem bipolaren Transistor oder einer Darlington-Konfiguration aus bipolaren Transistoren als elektronisches Schaltelement verwenden. Figur 3 zeigt einen solchen Zweidraht-Näherungsschalter. Das elektronische Schaltelement ist durch den bipolaren Transistor T9 gegeben, an dessen Basis der Eingang des DC-DC-Wandlers DC angeschlossen ist. Der Verstärker V' ist in diesem Fall mit einem npn-Transistor T5, dessen Kollektor über einen Widerstand R4 mit dem Anschluß a des Näherungsschalters und mit dem Basisanschluß eines pnp-Transistors T8 verbunden ist, dessen Emitter über einen Widerstand R10 ebenfalls mit dem Anschluß a verbunden ist. Die Basis des npn-Transistors T5 ist über einen Widerstand R5 mit dem Ausgang 10 der Steuerschaltung St und über einen Widerstand R12 mit Masse verbunden. Der Emitter des npn-Transistors T5 ist über einen Widerstand R11 mit Masse verbunden. Der Kollektor des pnp-Transistors T8 ist mit der Basis des, das elektronische Schaltelement bildenden Transistors T9 verbunden. Der Ausgang 11 der Steuerschaltung St ist mit der Stromquelle I verbunden.

Die in den Figuren 2 und 3 dargestellten Schaltungen eines induktiven Zweidraht-Näherungsschalters sind geeignet, einen durch einen Logic-Level-MOSFET T2 oder einen bipolaren Transistor T9 gebildeten elektronischen Schalter anzusteuern. Wird jedoch ein Leistungs-MOSFET oder ein IGBT-Schaltelement als elektronisches Schaltelement gewählt, so ist eine höhere Spannung an dessen Steuereingang zum sicheren Durchschalten nötig, als diese durch den Verstärker V bzw. V' erzeugt werden kann.

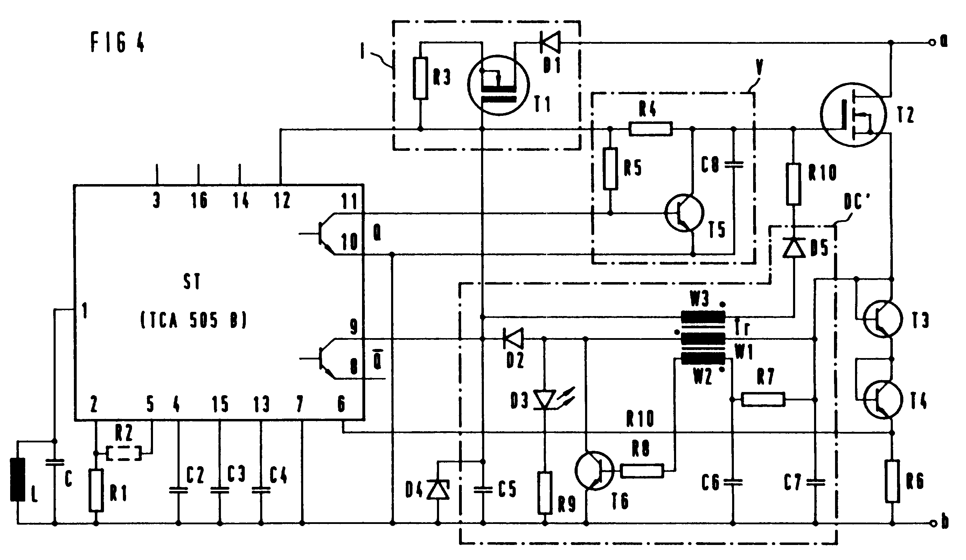

Eine ausreichend hohe Spannung wird durch die in Figur 4 gezeigte Schaltung erzeugt. Der dort dargestellte Transistor T2 ist ein Leistungs-MOSFET oder ein IGBT-Schaltelement. In Figur 4 werden gleiche Teile, wie sie bereits in Figur 2 erläutert wurden, mit gleichen Bezugszeichen versehen. Der DC-DC-Wandler DC' in Figur 4 ist gegenüber dem DC-DC-Wandler DC in Figur 2 um eine zweite Sekundärwicklung W3 erweitert, deren eines Ende mit dem ersten Ausgang des DC-DC-Wandlers DC' und deren zweites Ende über eine zweite Diode D5 mit einem zweiten Ausgang des DC-DC-Wandlers DC' verbunden ist, wobei der Wicklungssinn der zweiten Sekundärwicklung W3 entgegengesetzt zu dem der Primärwicklung W1 ist. Der zweite Ausgang des DC-DC-Wandlers DC' ist über einen Widerstand R10 mit dem Steueranschluß des Transistors T2 verbunden. Der Pufferkondensator dieses als Sperrwandler ausgebildeten zweiten Ausgangskreises des DC-DC-Wandlers DC' wird zum einen durch den Ausgangskondensator C8 des Verstärkers V und zum anderen durch die Gatekapazität des MOSFETs T2 gebildet.

Die erfindungsgemäßen selbstschwingenden DC-DC-Wandler, wie sie in den Figuren 2, 3 und 4 dargestellt sind, lassen sich natürlich nicht nur in den dort gezeigten induktiven Zweidraht-Näherungsschaltern verwenden, sondern genauso in jedem Zweidraht-Ein-Aus-Schalter, bei dem im durchgeschalteten Zustand des verwendeten elektronischen Schaltelements eine kleine Restspannung zur Versorgung einer nicht zum Betreiben eines getakteten DC-DC-Wandlers ausgelegten Steuerschaltung ausreichen muß.

**Patentansprüche**

1.  Zweidraht-Ein-Aus-Schalter, enthaltend:

    -   eine von außen ansteuerbare Steuerschaltung (St), die über eine Stromversorgungsschaltung (I) mit einem ersten Anschluß (a) zur Verbindung mit einer Spannungsquelle und mit einem zweiten Anschluß (b) zur Verbindung mit einer ebenfalls mit der Spannungsquelle verbundenen Last verbunden ist,
    -   ein von der Steuerschaltung (St) ansteuerbares elektronisches Schaltelement (S, T2, T9), das mit dem ersten Anschluß (a) und über ein einen Spannungsabfall erzeugendes Element (D, T3, T4, R6) mit dem zweiten Anschluß (b) verbunden ist, und
    -   einen taktgesteuerten, ein induktives Element enthaltenden DC-DC-Wandler (DC, DC'), der eingangsseitig mit dem Verbindungspunkt, der zwischen dem Schaltelement (S, T2, T9) und dem den Spannungsabfall erzeugenden Element (D, T3, T4, R6) gebildet wird, verbunden ist und ausgangsseitig mit der Steuerschaltung (St) zu deren Spannungsversorgung verbunden ist,

    **dadurch gekennzeichnet,**

    -   daß der DC-DC-Wandler vorgesehen ist mit einer Serienschaltung aus der Primärwicklung (W1) eines Transformators (Tr) und der Kollektor-Emitter-Strecke eines Transistors (T6), die parallel zu dem den Spannungsabfall erzeugenden, eine Eingangsspannungsquelle bildenden Element (D, T3, T4, R6) angeordnet ist, mit einer Serienschaltung aus einer ersten Diode (D2) und einem ersten Kondensator (C5), die parallel zur Kollektor-Emitter-Strecke des Transistors (T6) angeordnet ist, wobei die Spannung am ersten Kondensator (C5) als eine erste Ausgangsspannung des DC-DC-Wandlers die Steuerschaltung versorgt, und mit einer Serienschaltung aus einem ersten Widerstand (R7) und einem zweiten Kondensator (C6),die parallel zur Eingangsspannungsquelle (D, T3, T4, R6) angeordnet sind, wobei der Basisanschluß des Transistors (T6) über einen zweiten Widerstand (R8) und eine Sekundärwicklung (W2) des Transformators (Tr), deren Wicklungssinn entgegengesetzt zu dem der Primärwicklung (W1) ist, mit dem Verbindungspunkt des ersten Widerstands (R7) und des zweiten Kondensators (C6) verbunden ist.

2.  Zweidraht-Ein-Aus-Schalter nach Anspruch 1, **dadurch gekennzeichnet,** daß parallel zur Eingangsspannungsquelle (T2, T4, R6) ein dritter Kondensator (C7) angeordnet ist.

3.  Zweidraht-Ein-Aus-Schalter nach einem der Ansprüche 1 oder 2, **dadurch gekennzeichnet,** daß parallel zum ersten Kondensator (C5) eine Serienschaltung aus einer weiteren Sekundärwicklung (W3) des Transformators (Tr), deren Wicklungssinn entgegengesetzt zu dem der Primärwicklung (W1) ist, aus einer zweiten Diode (D5) und einem vierten Kondensator (C8) angeordnet ist, wobei die Spannung am vierten Kondensator (C8) eine zweite Ausgangsspannung des DC-DC-Wandlers (DC') ist.

4.  Zweidraht-Ein-Aus-Schalter nach Anspruch 1 oder 2, **dadurch gekennzeichnet,** daß das elektronische Schaltelement (S) ein Logic-Level-MOSFET (T2) ist.

5.  Zweidraht-Ein-Aus-Schalter nach Anspruch 3, **dadurch gekennzeichnet,** daß das elektronische Schaltelement (S) ein Leistungs-MOSFET oder ein IGBT-Transistor ist, dessen Steuereingang zusätzlich mit der zweiten Ausgangsspannung des DC-DC-Wandlers (DC') beaufschlagt ist.

6.  Zweidraht-Ein-Aus-Schalter nach einem der Ansprüche 1 oder 2, **dadurch gekennzeichnet,** daß das elektronische Schaltelement (S) ein bipolarer Transistor (T9) oder eine Darlington-Konfiguration bipolarer Transistoren ist.

7.  Zweidraht-Ein-Aus-Schalter nach Anspruch 6, **dadurch gekennzeichnet,** daß der Eingang des DC-DC-Wandlers (DC) mit der Basis des bipolaren Transistors (T9) verbunden ist.

8.  Zweidraht-Ein-Aus-Schalter nach einem der Ansprüche 1 bis 5, **dadurch gekennzeichnet,** daß das elektronische Schaltelement (S; T2; T9) über eine Verstärkerstufe (V; V') von der Steuerschaltung (St) angesteuert wird.

**Claims**

1. Two-wire on-off switch, containing:

   - an externally drivable control circuit (St) which is connected via a current supply circuit (I) to a first terminal (a) for connection to a voltage source and to a second terminal (b) for connection to a load which is likewise connected to the voltage source,
   - an electronic switching element (S, T2, T9) which can be driven by the control circuit (St) and is connected to the first terminal (a) and, via an element (D, T3, T4, R6) which produces a voltage drop, to the second terminal (b), and
   - a clock-controlled DC-DC converter (DC, DC') which contains an inductive element, is connected on the input side to the junction point formed between the switching element (S, T2, T9) and the element (D, T3, T4, R6) which produces the voltage drop, and is connected on the output side to the control circuit (St), for the voltage supply thereof,

   characterized

   - in that the DC-DC converter is provided, with a series circuit formed by the primary winding (W1) of a transformer (Tr) and the collector-emitter path of a transistor (T6), which series circuit is arranged in parallel with the element (D, T3, T4, R6) which produces the voltage drop and forms an input voltage source, with a series circuit formed by a first diode (D2) and a first capacitor (C5), which series circuit is arranged in parallel with the collector-emitter path of the transistor (T6), the voltage across the first capacitor (C5) supplying the control circuit as a first output voltage of the DC-DC converter, and with a series circuit formed by a first resistor (R7) and a second capacitor (C6) which are arranged in parallel with the input voltage source (D, T3, T4, R6), the base terminal of the transistor (T6) being connected to the junction point between the first resistor (R7) and the second capacitor (C6) via a second resistor (R8) and a secondary winding (W2) of the transformer (Tr) whose winding sense is opposite to that of the primary winding (W1).

2. Two-wire on-off switch according to Claim 1, characterized in that a third capacitor (C7) is arranged in parallel with the input voltage source (T2, T4, R6).

3. Two-wire on-off switch according to either of Claims 1 and 2, characterized in that a series circuit formed by a further secondary winding (W3) of the transformer (Tr) whose winding sense is opposite to that of the primary winding (W1), by a second diode (D5) and a fourth capacitor (C8) is arranged in parallel with the first capacitor (C5), the voltage across the fourth capacitor (C8) being a second output voltage of the DC-DC converter (DC').

4. Two-wire on-off switch according to Claim 1 or 2, characterized in that the electronic switching element (S) is a logic level MOSFET (T2).

5. Two-wire on-off switch according to Claim 3, characterized in that the electronic switching element (S) is a power MOSFET or an IGBT transistor, to whose control input the second output voltage of the DC-DC converter (DC') is additionally applied.

6. Two-wire on-off switch according to either of Claims 1 and 2, characterized in that the electronic switching element (S) is a bipolar transistor (T9) or a Darlington configuration of bipolar transistors.

7. Two-wire on-off switch according to Claim 6, characterized in that the input of the DC-DC converter (DC) is connected to the base of the bipolar transistor (T9).

8. Two-wire on-off switch according to one of Claims 1 to 5, characterized in that the electronic switching element (S; T2; T9) is driven by the control circuit (St) via an amplifier stage (V, V').

**Revendications**

1. Interrupteur marche-arrêt à deux fils, contenant :

   - un circuit de commande (St) qui peut être commandé de l'extérieur et qui est relié à une première borne (a) pour la connexion à une source de tension par le biais d'un circuit d'alimentation en courant électrique (I), et à une seconde borne (b) pour la connexion à une charge également reliée à la source de tension,

- un élément de commutation électronique (S, T2, T9) pouvant être commandé par le circuit de commande (St) et qui est relié à la première borne (a) et par le biais d'un élément (D, T3, T4, R6) produisant une chute de tension, à la seconde borne (b), et

- un convertisseur à courant continu (DC, DC') contenant un élément inductif et commandé par impulsions, qui est relié, côté entrée, au point de jonction formé entre l'élément de commutation (S, T2, T9) et l'élément (D, T3, T4, R6) produisant la chute de tension et, côté sortie, au circuit de commande (St) en vue de l'alimentation en tension de ce dernier, caractérisé en ce que le convertisseur à courant continu est prévu avec un montage en série formé par l'enroulement primaire (W1) d'un transformateur (Tr) et le circuit collecteur-émetteur d'un transistor (T6), qui est disposé en parallèle à l'élément (D, T3, T4, R6) produisant la chute de tension et formant une source de tension d'entrée; avec un montage en série formé par une première diode (D2) et un premier condensateur (C5) qui est disposé en parallèle au circuit collecteur-émetteur du transistor (T6), la tension aux bornes du premier condensateur (C5) alimentant le circuit de commande en tant que première tension de sortie du convertisseur à courant continu; et avec un montage en série formé par une première résistance (R7) et un second condensateur (C6) qui sont disposés en parallèle à la source de tension d'entrée (D, T3, T4, R6), la base du transistor (T6) étant reliée, par le biais d'une seconde résistance (R8) et d'un enroulement secondaire (W2) du transformateur (Tr) dont le sens d'enroulement est contraire à celui de l'enroulement primaire (W1), au point de jonction de la première résistance (R7) et du second condensateur (C6).

2.  Interrupteur marche-arrêt à deux fils selon la revendication 1, caractérisé en ce qu'un troisième condensateur (C7) est monté en parallèle à la source de tension d'entrée (T2, T4, R6).

3.  Interrupteur marche-arrêt à deux fils selon l'une des revendications 1 ou 2, caractérisé en ce qu'un montage en série qui est formé par un autre enroulement secondaire (W3) du transformateur (Tr) dont le sens d'enroulement est contraire à celui de l'enroulement primaire (W1), par une seconde diode (D5) et un quatrième condensateur (C8), est monté en parallèle au premier condensateur (C5), la tension aux bornes du quatrième condensateur (C8) étant une deuxième tension de sortie du convertisseur à courant continu (DC').

4.  Interrupteur marche-arrêt à deux fils selon la revendication 1 ou 2, caractérisé en ce que l'élément de commutation électronique (S) est un transistor MOS (T2) à niveau logique.

5.  Interrupteur marche-arrêt à deux fils selon la revendication 3, caractérisé en ce que l'élément de commutation électronique (S) est un transistor MOS de puissance ou un transistor IGBT dont l'entrée de commande reçoit, en plus, la deuxième tension de sortie du convertisseur à courant continu (DC').

6.  Interrupteur marche-arrêt à deux fils selon l'une des revendications 1 ou 2, caractérisé en ce que l'élément de commutation électronique (S) est un transistor bipolaire (T9) ou un montage Darlington de transistors bipolaires.

7.  Interrupteur marche-arrêt à deux fils selon la revendication 6, caractérisé en ce que l'entrée du convertisseur à courant continu (DC) est reliée à la base du transistor bipolaire (T9).

8.  Interrupteur marche-arrêt à deux fils selon l'une des revendications 1 à 5, caractérisé en ce que l'élément de commutation électronique (S; T2; T9) est commandé par le circuit de commande (St) par le biais d'un étage amplificateur (V; V').

FIG 1

FIG 2

ST
(TCA 505 B)

FIG 3

EP 0 692 159 B1

FIG 4

EP 0 692 159 B1